(19) Europäisches Patentamt
European Patent Office
Office européen des brevets

(11) **EP 2 769 002 B1**

(12) **EUROPÄISCHE PATENTSCHRIFT**

(45) Veröffentlichungstag und Bekanntmachung des Hinweises auf die Patenterteilung:
**30.09.2015 Patentblatt 2015/40**

(21) Anmeldenummer: **12795724.9**

(22) Anmeldetag: **17.10.2012**

(51) Int Cl.:
***C23C 14/34*** *(2006.01)* ***H01J 37/34*** *(2006.01)*

(86) Internationale Anmeldenummer:
**PCT/AT2012/000262**

(87) Internationale Veröffentlichungsnummer:
**WO 2013/056286 (25.04.2013 Gazette 2013/17)**

(54) **ROHRTARGET**

TUBULAR TARGET

CIBLE TUBULAIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.10.2011 AT 5622011**

(43) Veröffentlichungstag der Anmeldung:
**27.08.2014 Patentblatt 2014/35**

(73) Patentinhaber: **Plansee SE**
**6600 Reutte (AT)**

(72) Erfinder:
• **ABENTHUNG, Peter**
**6600 Reutte (AT)**

• **LINKE, Christian**
**6600 Ehenbichl (AT)**
• **DRONHOFER, André**
**6600 Reutte (AT)**
• **WOLF, Hartmut**
**6600 Breitenwang (AT)**
• **WILL, Tobias**
**97285 Röttingen (DE)**
• **KÖCK, Wolfgang**
**6600 Reutte (AT)**

(56) Entgegenhaltungen:
**EP-A1- 0 586 809        WO-A1-2007/041730**
**WO-A1-2007/141174     WO-A1-2010/116111**
**US-A1- 2005 279 630**

EP 2 769 002 B1

**Beschreibung**

Die Erfindung betrifft ein Rohrtarget aus Refraktärmetall oder einer Refraktärmetalllegierung mit einem Refraktärmetallgehalt > 50 At.%, das zumindest einen Rohrabschnitt X mit einer relativen Dichte RDx und zumindest einen Rohrabschnitt Y mit einer relativen Dichte RDy umfasst, wobei zumindest ein Rohrabschnitt X zumindest bereichsweise einen größeren Außendurchmesser als zumindest bereichsweise ein Rohrabschnitt Y aufweist. Weiters betrifft die Erfindung ein Verfahren zur Herstellung eines Rohrtargets aus einem Refraktärmetall oder einer Refraktärmetalllegierung mit einem Refraktärmetallgehalt > 50 At.%, wobei das Verfahren zumindest die folgenden Schritte umfasst: Herstellen eines Grünling durch Pressen eines Pulvers mit einem Pressdruck p, mit 100 MPa < p < 400 MPa und Herstellen eines Rohrrohlings durch druckloses oder druckunterstütztes Sintern bei 0,4 bis 0,9 homologe Temperatur und optional mechanische Bearbeitung.

Unter Rohrtarget ist dabei eine rohrförmige Zerstäubungsquelle für eine Kathodenzerstäubungsanlage zu verstehen. Die Kathodenzerstäubung wird üblicherweise auch Sputtern genannt, die Zerstäubungsquellen Sputtering Targets. Ein Rohrtarget ist daher ein Sputtering Target mit Rohrform. Ein besonders in der Mikroelektronik häufig eingesetztes Verfahren ist das Magnetronsputtern. Während bei der einfachen Kathodenzerstäubung lediglich ein elektrisches Feld angelegt wird, wird beim Magnetronsputtern zusätzlich ein Magnetfeld erzeugt. Durch die Überlagerung von elektrischem und magnetischem Feld wird der Weg der Ladungsträger verlängert und die Zahl der Stöße pro Elektron erhöht.

Ein Vorteil von Rohrtargets ist der gleichmäßige Abtrag und damit ein hoher Ausnutzungsgrad. Unter Ausnutzungsgrad versteht man die abgesputterte Materialmasse während der gesamten Einsatzzeit des Targets, bezogen auf die Masse des Targets vor dem ersten Einsatz. So liegt der Ausnutzungsgrad für planare Targets bei ca. 15 bis 40 % und für Rohrtargets typischerweise bei 75 bis 85 %. Die im Innenraum des Rohrtargets realisierte Targetkühlung ist durch den günstigeren Wärmeübergang im Rohr wesentlich wirksamer, als bei Beschichtungsraten ermöglicht. Zudem ist auch die Neigung zu lokaler Lichtbogenbildung (wird auch als Arcen bezeichnet) insbesondere beim reaktiven Sputtern reduziert. Der Einsatz von Rohrtargets ist dann besonders vorteilhaft, wenn großflächige Substrate beschichtet werden. Während des Einsatzes rotiert das Rohrtarget langsam, während üblicherweise das Magnetfeld stationär ist. Die Elektronendichte ist dabei an der Stelle am höchsten, wo die Lorentzkraft parallel zur Target-Oberfläche liegt. Dies bewirkt eine höhere Ionisation in diesem Bereich. Obwohl durch eine optimierte Anordnung der Magnete der Sputterabtrag zu einem gewissen Ausmaß über die Länge des Targets vergleichmäßigt werden kann, ist dieser im Bereich der Rohrenden höher, als im mittleren Bereich des Rohrtargets. Durch den erhöhten Materialabtrag im Bereich der Rohrenden werden die Bereiche des zu beschichtenden Substrates, die direkt in der Nähe der Enden des Rohrtargets liegen, mit einer anderen Schichtdicke als der Rest des Substrates belegt. Der verstärkte Materialabtrag an den Rohrenden limitiert außerdem die mögliche Materialausnutzung des Rohrtargets, da nach dem Ende des Beschichtungsprozesses ein gewisser Restanteil an Targetmaterial vor allem im Mittenbereich des Rohrtargets verbleibt, der damit zur Beschichtung nicht genutzt werden kann. Dies limitiert den Ausnutzungsgrad.

In der EP 0 586 809 A1 wird ein Rohrtarget beschrieben, bei dem die Enden einen größeren Außendurchmesser als der Mittenbereich des Rohrtargets aufweisen. Dadurch kann die Materialausnutzung des Targets deutlich erhöht werden. Dieses Verfahren ist für Targetmaterialien, die über thermisches Spritzen aufgebracht werden, geeignet. Bei anderen Herstellverfahren kann diese Geometrie allerdings nur über zusätzliche Bearbeitungsschritte und einen erhöhten Materialeinsatz eingestellt werden. Außerdem wird die mögliche Erhöhung der Materialdicke an den Targetenden durch die Schwächung der magnetischen Feldstärke bestimmt, die gerade bei Refraktärmetallen bei einer zu starken Materialbelegung beachtet werden muss. Zudem kann durch den Einsatz von Rohrtargets, die im Bereich der Rohrenden einen größeren Außendurchmesser aufweisen, zwar die Einsatzzeit der Rohrtargets verlängert, nicht jedoch der ungleichmäßige Abtrag vermieden werden.

Diesen ungleichmäßigen Abtrag auszugleichen, haben die WO 2007/141173 A1 und die WO 2007/141174 A1 zum Ziel.
In der WO 2007/141174 A1 wird dies durch Rohrendbereiche erzielt, die aus einem Werkstoff gebildet sind, der eine chemische Verbindung eines im Mittenbereich enthaltenen Elements enthält. In der WO 2007/141173 A1 wird dieser Endbereich durch thermisches Spritzen hergestellt. Für Anwendungen, vor allem im Bereich der Mikroelektronik, besteht jedoch der Wunsch aufgrund der sehr hohen Anforderungen in Hinblick auf die Werkstoffhomogenität der abgeschiedenen Schicht auch Sputtering Targets mit homogener Werkstoffzusammensetzung einzusetzen.

Die Herstellung von Rohrtargets mit einem höheren Ausnutzungsgrad durch das Anbringen von Endstücken aus einem anderen Material als das zu sputternde Targetmaterial wird in der US 5,725,746 (A) beschrieben. Dieses zusätzlich angebrachte Material wird dabei mit einer langsameren Abtragsrate als das eigentliche Targetmaterial gesputtert. Allerdings werden dabei Verunreinigungen in die Dünnschicht eingebracht. Außerdem können mit diesem Verfahren keine trägerrohrlosen Rohrtargets hergestellt werden.

Rohrtargets werden überwiegend für die Herstellung großflächiger Beschichtungen verwendet. Der hohe Ausnutzungsgrad des Targetmaterials ist insbesondere bei teuren Schichtmaterialien, wie beispielsweise Refraktärmetallen, ein Vorteil. Unter Refraktärmetall versteht man dabei ein Metall der 4. Nebengruppe (Titan, Zirconium und Hafnium), 5. Nebengruppe (Vanadium, Niob und Tantal), der 6. Nebengruppe (Chrom, Molybdän und Wolfram) sowie Rhenium. Ihr Schmelzpunkt liegt über dem von Platin (1772 °C). Refraktärmetalle weisen ein für viele Anwendungen sehr interessantes Eigenschaftsprofil auf. Aufgrund des hohen Schmelzpunkts ist grundsätzlich die Fremddiffusionsrate gering, was sie für den Einsatz als Diffusionsbarrieren prädestiniert. Weiters bilden speziell Molybdän und Wolfram mit vielen Schichtwerkstoffen einen ohmschen Kontakt, wodurch eine Schottky-Barriere vermieden wird. Die hohe elektrische Leitfähigkeit speziell von Molybdän, Wolfram und Chrom ist für den Einsatz als Leitbahn von Vorteil. Der niedrige thermische Ausdehnungskoeffizient speziell von Molybdän, gute Schichthaftung und niedrige Schichtspannungen. Sputtering Targets aus Refraktärmetallen werden nach wie vor bevorzugt planar ausgeführt.

Für die Herstellung von Rohrtargets aus Refraktärmetallen wurden bereits viele Herstellverfahren erprobt, wie beispielsweise Gießverfahren, heißisostatisches Pressen, Sintern, Strangpressen oder diverse Spritztechniken. Ein vorteilhaftes pulvermetallurgisches Herstellverfahren von Molybdän Rohrtargets ist beispielsweise in der WO 2007/041730 A1 beschrieben.

Der Erfindung liegt daher die Aufgabe zugrunde, ein Rohrtarget bereitzustellen, das zumindest einen im Stand der Technik angeführten Nachteil nicht aufweist. Aufgabe der Erfindung ist es weiters, ein Rohrtarget bereitzustellen, das im Sputterprozess gleichmäßig abgetragen wird und zu keiner örtlich unzulässig erhöhten Sputterrate neigt. Weiters ist es Aufgabe der Erfindung ein Rohrtarget bereit zu stellen, das einen hohen Ausnutzungsgrad aufweist. Eine weitere Aufgabe der Erfindung ist es, ein Rohrtarget bereitzustellen, mit dem Schichten mit hoher Gleichmäßigkeit der Schichtdicke über eine große Fläche abgeschieden werden können. Zudem ist es Aufgabe der Erfindung ein Rohrtarget bereitzustellen, das möglichst geringfügig zu lokaler Lichtbogenbildung (Arcen) und Teilchengenerierung neigt. Weiters ist es Aufgabe der Erfindung ein kostengünstiges Verfahren zur Herstellung von Rohrtargets bereitzustellen, das zumindest eine der zuvor genannten Eigenschaften aufweist.

Die Aufgabe wird durch die unabhängigen Ansprüche 1, 16, 17 gelöst.

Das Rohrtarget umfasst dabei zumindest ein Rohrabschnitt X mit zumindest bereichsweise einer relativen Dichte RDx und zumindest ein Rohrabschnitt Y mit zumindest bereichsweise einer relativen Dichte RDy. Der Rohrabschnitt X weist zumindest bereichsweise einen größeren Außendurchmesser auf, als zumindest bereichsweise der Rohrabschnitt Y. Das Dichteverhältnis erfüllt zumindest bereichsweise die folgende Beziehung: $(RDy - RDx) / RDy \geq 0,001$. Ist das Dichteverhältnis geringer, werden die nachstehend angeführten Vorteile nicht mehr ausreichend erzielt. Unter relativer Dichte ist dabei die gemessene Dichte, bezogen auf die theoretische Dichte des jeweiligen Werkstoffs zu verstehen. Die theoretische Dichte eines Werkstoffs entspricht der Dichte von porenfreiem, 100 % dichtem Material.

Die vorteilhafte Wirkung der Erfindung ist bei Refraktärmetallen und Refraktärmetall-Legierungen gegeben. Refraktärmetalle und Refraktärmetall-Legierungen weisen eine hohe Sputterbeständigkeit auf. Refraktärmetalle umfassen die Metalle der 4. Nebengruppe (Titan, Zirkonium und Hafnium), der 5. Nebengruppe (Vanadium, Niob und Tantal), der 6. Nebengruppe (Chrom, Molybdän und Wolfram) sowie Rhenium. Unter einer Refraktärmetall-Legierung ist eine Legierung zumindest eines oder mehrerer Refraktärmetalle zu verstehen, wobei der Refraktärmetall-Gehalt in Summe größer/gleich 50 Atom% beträgt. Bei Refraktärmetallen und Refraktärmetall-Legierungen reicht schon ein sehr geringer Dichteunterschied zwischen den Rohrabschnitten X und Y aus, um einen gleichmäßigeren Sputterabtrag zu erreichen. Als besonders bevorzugte Refraktärmetalle haben sich dabei die vergleichsweise spröden Werkstoffe der 6. Nebengruppe, nämlich Chrom, Molybdän, Wolfram und deren Legierungen, erwiesen. Dabei sind wiederum Molybdän und Molybdänlegierungen hervorzuheben.

Die Bestimmung der Dichte folgt dem Prinzip des Archimedes, das die Beziehung zwischen Masse, Volumen und Dichte eines in Flüssigkeit eingetauchten Festkörpers beschreibt. Mit Hilfe der sogenannten Auftriebsmethode wird das Gewicht, vermindert um die Auftriebskraft, bestimmt und daraus sowie aus dem Gewicht an Luft die relative Dichte berechnet.

Im Folgenden wird die Probenahme zur Ermittlung von RDx und RDy beschrieben. Mit der Auftriebsmethode kann man bereits die Dichte kleiner Volumina zuverlässig bestimmen. Bei Bestimmung der Dichte eines Rohrabschnitts eines Rohrtargets wird das minimale Volumen durch die minimale Dicke einer Scheibe des Rohrabschnitts bestimmt. Die minimal erreichbare Dicke wird wiederum von der Expertise für die Bearbeitung bestimmt. Eine Scheibe des Rohrabschnitts von 3 mm Dicke kann unabhängig von der vorliegenden Expertise zuverlässig hergestellt werden und wird daher der Bestimmung von RDx und RDy zugrunde gelegt. Bevorzugt werden die Proben im Bereich des größten Außendurchmessers des Rohrabschnitts X und im Bereich des kleinsten Außendurchmessers des Rohrabschnitts Y entnommen.

Es hat sich nun gezeigt, dass bei Vorliegen eines Rohrtargets mit den erfinderischen Merkmalen der Sputterabtrag über die Länge des Rohrtargets gleichmäßiger als bei Targets gemäß dem Stand der Technik ist. Ein über die Länge des Rohrtargets gleichmäßiger Sputterabtrag gewährleistet einen hohen Ausnutzungsgrad. Der Ausnutzungsgrad hängt dabei vom RDy zu RDx Verhältnis, von den Sputterparametern, wie beispielsweise der Bias-Spannung und vom Sputterwerkstoff ab. Weiters bedeutet ein gleichmäßiger Sputterabtrag auch eine gleichmäßige Sputterrate. Eine über die Länge des Rohrtargets gleichmäßige Sputterrate führt wiederum zu abgeschiedenen Schichten, die über die gesamte Fläche eine sehr gleichmäßige Schichtdicke aufweisen. Diese gleichmäßige Schichtdicke wird auch bei großflächig abgeschiedenen Schichten erzielt. Weiters hat es sich gezeigt, dass die erfindungsgemäßen Rohrtargets weder unzulässig stark zum Arcen, noch zur Teilchengenerierung neigen und damit weniger Schichtfehler bewirken.

Bevorzugt werden die mittleren relativen Dichten RDxm und RDym eines größeren Volumens bestimmt, wobei RDxm die mittlere relative Dichte zumindest eines Bereichs des Rohrabschnitts X und RDym die mittlere relative Dichte zumindest eines Bereichs des Rohrabschnitts Y bezeichnet. Zur Bestimmung von RDxm und RDym wird ein Rohrabschnitt mit einer Dicke von 50 mm entnommen. Die Proben für die Dichtebestimmung werden dabei bevorzugt im Bereich des größten Außendurchmessers des Rohrabschnitts X und des kleinsten Außendurchmessers des Rohrabschnitts Y genommen. Bevorzugt sind die Werte für RDx und RDxm ident. Auch die Werte für RDy und RDym sind bevorzugt ident. Weiters beträgt bevorzugt das Verhältnis der mittleren relativen Dichten (RDym - RDxm) / RDym ≥ 0,001.

Eine bevorzugte Ausführungsform liegt auch vor, wenn zumindest ein Verhältnis der relativen Dichten der Gruppe (RDy - RDx) / RDy und (RDym - RDxm) / RDym ≥ 0,005 oder ≥ 0,01 oder ≥ 0,02 oder ≥ 0,05 oder ≥ 0,1 beträgt. Das optimale Verhältnis ist dabei von den Sputterbedingungen und dem gesputterten Werkstoff abhängig. Dadurch wird ein sehr gleichmäßiges Sputterverhalten erzielt. Weiters beträgt bevorzugt zumindest ein Verhältnis aus der Gruppe (RDy - RDx) / RDy und (RDym - RDxm) / RDym ≤ 0,2. Ist das Verhältnis der relativen Dichten bzw. der mittleren relativen Dichten größer als 0,2, weist der Bereich X eine vergleichsweise geringe Dichte auf, wodurch es in Abhängigkeit vom Werkstoff und den Sputterparametern zu verstärkter Teilchengenerierung und/oder lokaler Arc Bildung kommen kann.

Weiters ist es vorteilhaft, wenn die relative Dichte des Rohrabschnitts Y 99 bis 100 % beträgt. Der Rohrabschnitt X weist bevorzugt eine feine und gleichmäßige Porenstruktur auf. Damit ist eine sehr niedrige Neigung zur Teilchengenerierung und Arc Bildung gewährleistet. Eine feine und gleichmäßige Porenstruktur wird bevorzugt dann erreicht, wenn das Rohrtarget pulvermetallurgisch hergestellt ist. Eine pulvermetallurgische Herstellung ergibt Gefügemerkmale, wie beispielsweise Größe und Verteilung der Restporosität, die schmelzmetallurgisch nicht herstellbar sind. So liegt bevorzugt der mittlere Porendurchmesser im Rohrabschnitt X bei 10 nm bis 10 μm.

Weiters sind bevorzugt zumindest Bereiche der Rohrtargetenden als Rohrabschnitt X ausgebildet. Zumindest ein Rohrabschnitt Y ist bevorzugt zwischen den Rohrabschnitten X angeordnet. Bevorzugt erstreckt sich in axialer Richtung der Rohrabschnitt Y über einen größeren Bereich, als die Summe der zwei Rohrabschnitte X. Damit wird gewährleistet, dass die Rohrabschnitte X dort angeordnet sind, wo die höchste Plasmadichte auftritt.

Weiters weisen bevorzugt alle Rohrabschnitte X und alle Rohrabschnitte Y dieselbe Werkstoffzusammensetzung auf. Die Zusammensetzung der Rohrabschnitte X und Y liegt dabei bevorzugt innerhalb des für den jeweiligen Werkstoff spezifizierten Bereichs. In anderen Worten, das gesamte Rohrtarget ist aus demselben Werkstoff gefertigt. Das ist speziell für Anwendungen im Bereich der Elektronik sehr vorteilhaft, da bereits geringfügige Konzentrationsunterschiede einen großen Einfluss auf die funktionalen Schichteigenschaften ausüben.

Weiters ist es vorteilhaft, wenn das Rohrtarget einteilig ausgeführt ist. Damit werden Fügestellen, wie dies bei mehrteilig-gefügten Rohrtargets der Fall ist, vermieden. Einteilig ausgeführte Rohrtargets neigen deutlich weniger zur Teilchengenerierung.

Weiters beträgt bevorzugt zumindest bereichsweise für einen Rohrabschnitt X und zumindest bereichsweise für einen Rohrabschnitt Y das Durchmesserverhältnis (ADx - ADy) / ADx ≥ 0,01, wobei ADx der maximale Außendurchmesser des Rohrabschnitts X und ADy der kleinste Außendurchmesser des Rohrabschnitts Y ist. Liegt das Durchmesserverhältnis unter 0,01 kann der unterschiedliche Abtrag nur durch eine geringe Dichte im Rohrabschnitt X ausgeglichen werden. Bevorzugt beträgt das Verhältnis der Außendurchmesser (ADx - ADy) / ADx ≤ 0,3. Ein größeres Verhältnis bedeutet auch eine örtlich unterschiedliche Distanz zwischen Rohrtarget und Substrat. Eine bevorzugte Ausführungsform liegt weiters vor, wenn das Rohrtarget zwei Rohrabschnitte X und ein Rohrabschnitt Y umfasst, wobei der Rohrabschnitt Y zwischen den Rohrabschnitten X angeordnet ist. Zwischen den Rohrabschnitten X und dem Rohrabschnitt Y kann dabei der Übergang fließend oder scharf ausgeführt werden. Ein fließender Übergang bedeutet, dass sich zwischen Rohrabschnitt X und dem Rohrabschnitt Y ein weiterer Abschnitt Z befindet, wobei sich der Außendurchmesser im Abschnitt Z vom Außendurchmesser des anschließenden Bereiches von Rohrabschnitt X auf den Außendurchmesser des anschließenden Bereiches von Rohrabschnitt Y ändert. Eine weitere bevorzugte Ausführungsform liegt vor, wenn das Rohrtarget zwei Rohrabschnitte X mit gleichem Außendurchmesser aufweist. Eine weitere bevorzugte Ausführungsform liegt weiters vor, wenn der Rohrabschnitt Y über zumindest 80 % der Länge einen konstanten Außendurchmesser aufweist. Zudem ist der Innendurchmesser bevorzugt über die gesamte Länge des Rohrtargets konstant groß. In einer weiteren bevorzugten Ausführungsform ändert sich in zumindest einem Rohrabschnitt X der Außendurchmesser von ADx auf ADy. In anderen Worten ausgedrückt, der Rohrabschnitt X ist konisch ausgeführt.

Weiters kann das Rohrtarget monolithisch ausgeführt oder mit einem Trägerrohr aus einem nicht magnetischen Werkstoff verbunden sein. Monolithisch bedeutet, dass auch das Anschlussstück aus dem Sputtermaterial besteht. Ist das Rohrtarget mehrteilig auszuführt, können die Rohrabschnitte X, Y und/oder Z durch ein Trägerrohr fixiert sein. Die einzelnen Rohrabschnitte können dabei nur nebeneinander angeordnet oder mittels eines Fügeverfahrens, wie beispielsweise Diffusionsschweißen, miteinander verbunden sein. Wenn das Rohrtarget mit einem Trägerrohr verbunden ist, kann dies beispielsweise mittels einer Lötverbindung oder auch einer Schraubenverbindung erfolgen.

Bevorzugt wird das Rohrtarget für Beschichtungsaufgaben verwendet, wo höchste Schichtqualität gefordert wird. Insbesondere ist dies bei der Herstellung von Rückkontaktschichten einer Dünnschichtsolarzelle, bevorzugt aus Molybdän oder einem Natrium-haltigen Molybdän Werkstoff, oder einer Funktionsschicht einer TFT-Struktur, bevorzugt aus Wolfram, Molybdän oder einer Molybdänlegierung, wie beispielsweise Mo-Ta, Mo-W, Mo-Cr, Mo-Nb oder Mo-Ti, der Fall.

Weiters wird die Aufgabenstellung der Erfindung mittels eines Verfahrens zur Herstellung eines Rohrtargets gelöst, wobei das Rohrtarget aus einem Refraktärmetall oder einer Refraktärmetall-Legierung besteht.

Die Rohlingsherstellung kann dabei weitgehend gemäß dem in der EP 1 937 866 A1 offenbarten Verfahren erfolgen, nämlich durch Herstellen eines Grünlings durch Pressen eines Pulvers mit einem Pressdruck p, mit 100MPa<p<400MPa; und Herstellen eines Rohrrohlings durch druckloses oder druckunterstütztes Sintern bei 0,4 bis 0,9 homologe Temperatur und optional mechanischer Bearbeitung. Von homologer Temperatur spricht man, wenn ein Temperaturverhältnis auf den absoluten Schmelzpunkt eines Werkstoffs bezogen ist.

Der Rohrrohling wird nun in dem Bereich, der im fertigen Rohrtarget dem Rohrabschnitt Y entspricht, so verformt, dass zumindest bereichsweise der Umformgrad höher ist als in dem Bereich, der im fertigen Rohrtarget dem Rohrabschnitt X entspricht. Der Umformgrad ist eine

Formänderungskenngröße, mit der die bleibende geometrische Veränderung eines Werkstücks beim Umformprozess erfasst wird.

Für die Verformung eines Rohres ist der Umformgrad folgendermaßen definiert:

$$\varphi = ln\frac{A1}{Ao} \ ,$$

mit

A$_1$...Querschnittsfläche im jeweiligen Endzustand,
A$_0$...Querschnittsfläche im jeweiligen Ausgangszustand.

Der Rohrrohling wird nun bevorzugt in einem Bereich, der im fertigen Rohrtarget dem Rohrabschnitt Y entspricht, zumindest bereichsweise um $|\varphi| \geq 0,03$ höher verformt, als zumindest bereichsweise in einem Bereich, der im fertigen Rohrtarget dem Rohrabschnitt X entspricht. Da eine Querschnittsreduktion zu einem negativen Wert für φ führt, ist der absolute Betrag $|\varphi|$ angegeben. Den absoluten Betrag $|\varphi|$ erhält man durch Weglassen des Vorzeichens. Bevorzugt beträgt $|\varphi| \geq 0,1$, besonders bevorzugt $|\varphi| \geq 0,3$. Weiters beträgt bevorzugt $|\varphi| \leq 3$. Ist $|\varphi| < 0,03$ oder ist $|\varphi| > 3$ können die bevorzugten Dichteverhältnisse nur mit höherem prozesstechnischen Aufwand erreicht werden.

Es hat sich nun gezeigt, dass das erfindungsgemäße Herstellverfahren besonders für die Herstellung von Refraktärmetall-Legierungen geeignet ist, während es bei anderen Werkstoffen, wie z.B. niedrigschmelzenden, sehr weichen Werkstoffen, wie Kupfer oder Aluminium nicht vorteilhaft ist.

Grundsätzlich unterscheidet der Fachmann zwei Urformtechniken, nämlich schmelzmetallurgische und pulvermetallurgische Techniken. Schmelzmetallurgische Techniken sind nachteilig, da hier keine Porosität, die aus vielen kleinen, sehr gleichmäßig verteilten Poren besteht, erzeugt werden kann. Ein weiterer Vorteil pulvermetallurgischer Verfahrenstechniken besteht darin, dass nun ausgehend von einem porösen Grünling, ein Sinterling mit definierter relativer Dichte hergestellt werden kann. Auch der Verdichtungsprozess kann so erfolgen, dass eine für einen gleichmäßigen Sputterabtrag besonders vorteilhafte Mikrostruktur entsteht.

Grundsätzlich ist es auch möglich, bereits im Grünling Bereiche mit unterschiedlicher Dichte einzustellen. So kann der Grünling beispielsweise so hergestellt werden, dass dieser bereits im grünen Zustand Bereiche mit niederer Dichte und Bereiche mit höherer Dichte entsprechend den zu erzielenden Dichtewerten im Rohrtarget aufweist. Die Herstellung des Grünlings erfolgt dabei bevorzugt durch kaltisostatisches Pressen. Dabei wird das Pulver typischerweise in einen flexiblen Schlauch gefüllt, der allseits abgedichtet und in einer kaltisostatischen Presse positioniert wird. In der kaltisostatischen Presse wird ein Flüssigkeitsdruck bevorzugt im Bereich von 100 bis 400 MPa aufgebracht, wodurch es zu einer Verdichtung kommt. Verwendet man nun über die gesamte Länge des Grünlings ein Pulver mit gleicher Partikelgröße, so sind auch die relative Dichte und damit die Porosität über die gesamte Länge annähernd konstant. Füllt man aber in den Schlauch zunächst ein feines Pulver, beispielsweise für Molybdän oder Wolfram mit 1,5 bis 3 μm FSSS (FSSS = Fisher Subsieve Size), und zwar in den Bereich, der später im fertigen Rohrtarget dem Rohrabschnitt X entspricht, und ein Pulver mit einer größeren Partikelgröße, für Molybdän oder Wolfram beispielsweise mit 3 bis 6 μm FSSS, in den Bereich, der dem Rohrabschnitt Y im fertigen Rohrtarget entspricht, so erreicht man im grünen Zustand eine unterschiedliche Dichteverteilung. Dort wo die Partikelgröße kleiner ist, ist die Dichte geringer und im Bereich mit gröberem Pulverkorn höher. Erfolgt nun beispielsweise die weitere Verdichtung durch heißisostatisches Pressen bei vergleichsweise tiefen Temperaturen, beispielsweise im Bereich 0,4 bis 0,6 homologe Temperatur, so bleibt auch nach dem Verdichtungsvorgang ein Dichteunterschied bestehen. Es ist jedoch auch möglich, das unterschiedliche Sintervermögen von feinem und grobem Pulver auszunützen, wobei bei der üblichen Sintertemperatur (0,6 bis 0,9 homologe Temperatur) ohne Druckeinwirkung ein feines Pulver deutlich stärker sintert und damit besser verdichtet als ein Grünling, der aus gröberen Pulver gefertigt wird. Dieser Effekt kann folgendermaßen ausgenützt werden. Es wird zunächst ein Grünling hergestellt, der in dem Bereich, der später dem Rohrabschnitt X entspricht, mit gröberem Pulver (für Molybdän oder Wolfram beispielsweise mit 3 bis 6 μm FSSS) gefüllt und in dem Bereich, der später dem Rohrabschnitt Y entspricht, mit feinem Pulver gefüllt wird (für Molybdän oder Wolfram beispielsweise mit 1,5 bis 3 μm FSSS). Die Gründichte ist nun im Rohrabschnitt X höher als im Rohrabschnitt Y. Bei einem anschließenden Sinterprozess ohne Druckeinwirkung, typischerweise im Temperaturbereich 0,6 bis 0,9 homologe Temperatur, verdichtet nun der Grünlingsbereich, der aus feinem Pulver hergestellt wurde stärker, als der Bereich der aus gröberem Pulver hergestellt wurde, wodurch auch die unterschiedlichen Gründichten mehr als kompensiert werden.

Weiters kann die Form des Grünlings aus der Gruppe Rohr, Zylinder, Rohr mit bereichsweise größerem Außendurchmesser und Zylinder mit bereichsweise größerem Außendurchmesser gewählt werden. Wird ein Zylinder hergestellt, so muss nach dem Sinterprozess eine Rohrluppe durch mechanisches Bearbeiten erzeugt werden. Vorteilhaft ist es, bereits ein Rohr zu pressen. Dazu wird in den Gummischlauch ein Dorn eingeführt, wodurch der Hohlraum des Rohres presstechnisch hergestellt wird.

Weiters kann es auch vorteilhaft sein, bereits einen Grünling mit einem größeren Außendurchmesser im Bereich zumindest eines Rohrendes herzustellen. Als sehr vorteilhaft hat es sich jedoch erwiesen, einen Grünling herzustellen, der über sein gesamtes Volumen eine gleichmäßige Gründichte sowie einen annähernd gleichen Außen- und Innendurchmesser aufweist. Das Sintern wird so durchgeführt, dass die mittlere relative Sinterdichte RDr die folgende Beziehung erfüllt: 0,80 ≤ RDr ≤ 0,995. Bei einem hohen RDr-Wert kann es in Abhängigkeit von den Sputterbedingungen vorteilhaft sein, wenn der Rohrabschnitt X nicht verformt wird. Ist die Sinterdichte kleiner als 0,80, kann der Sinterling nur mit einigem Aufwand fehlerfrei verformt werden. Zudem nehmen das unerwünschte Arcen und die Teilchengenerierung stark zu. Eine Sinterdichte über 0,995 führt zu Grobkornbildung. Wird bereits presstechnisch ein Grünling mit Rohrform hergestellt, so weist der Sinterling eine Rohrform auf und wird als Rohrrohling bezeichnet. Die Herstellung eines Rohrrohlings kann auch optional mechanisch erfolgen. Diese mechanische Bearbeitung ist dann unabdinglich, wenn der Grünling als Zylinder hergestellt wird. Der Rohrrohling kann in weiterer Folge über die gesamte Länge vorverformt werden. Als Umformverfahren eignen sich beispielsweise Strangpressen und Schmieden.

Der so hergestellte vorverformte Rohrrohling weist bevorzugt eine relative Dichte von 0,85 bis 0,995 auf.

Die Herstellung des höher verformten Rohrabschnitts Y erfolgt bevorzugt durch ein Verfahren der Gruppe Schmieden und Drückwalzen. Der Rohrrohling wird dabei bevorzugt so verformt, dass zumindest in einem Bereich, der im fertigen Rohrtarget zumindest teilweise dem Rohrabschnitt Y entspricht, |φ| ≥ 0,03 höher ist, als zumindest in einem Bereich, der im fertigen Rohrtarget zumindest teilweise dem Rohrabschnitt X entspricht. Der Rohrrohling kann auch wie erwähnt zunächst durch Strangpressen und/oder Schmieden verformt werden. Der so hergestellte vorverformte Rohrrohling wird durch Schmieden und/oder Drückwalzen so verformt, dass zumindest in einem Bereich, der im fertigen Rohrtarget zumindest teilweise dem Rohrabschnitt Y entspricht, |φ| ≥ 0,03 höher ist, als zumindest in einem Bereich, der im fertigen Rohrtarget zumindest teilweise dem Rohrabschnitt X entspricht.

Als Umformtemperatur kann die für den jeweiligen Werkstoff übliche Temperatur gewählt werden. Der Umformgrad φ im Rohrabschnitt X beträgt bevorzugt -3 ≤ φ ≤ 0, besonders bevorzugt -2,5 ≤ φ ≤ -0,3.

Wird ein Grünling mit homogener Dichteverteilung eingesetzt, kann durch Wahl des lokalen Umformgrades die lokale Dichte zuverlässig eingestellt werden. Als Einflussgrößen gehen dabei die Form des Grünlings und des geschmiedeten Rohrs ein. Der Rohrrohling weist bevorzugt Rohrform mit annähernd konstantem Außen- und Innendurchmesser auf. Der dem Rohrabschnitt X entsprechende Bereich, bevorzugt die Rohrenden, wird geringer und der dem Rohrabschnitt Y entsprechende Bereich höher verformt. Da die Dichte mit steigendem Umformgrad steigt, weist nach der Umformung der Bereich Y eine höhere Dichte auf. Mit diesem Verfahren lassen sich Rohrtargets herstellen, die ein sehr gleichmäßiges Sputterverhalten, eine geringe Neigung zu Arc-Bildung und Teilchengenerierung aufweisen.

Bevorzugt ist ein Rohrtarget, nach dem erfindungsgemäßen Verfahren hergestellt, durch eine oder mehrere Eigenschaften der nachfolgenden Gruppe gekennzeichnet, nämlich dass (RDy-RDx)/RDy ≥ 0,001; dieses aus einem Werkstoff der Gruppe Molybdän, Molybdänlegierung, Wolfram, Wolframlegierung, Chrom und Chromlegierung besteht; die Rohrenden als Rohrabschnitte X ausgebildet sind und zumindest ein Bereich Y dazwischen angeordnet ist, der sich über einen größeren Bereich erstreckt, als die Summe der zwei Rohrabschnitte X; alle Rohrabschnitte X und alle Rohrabschnitte Y eine idente Werkstoffzusammensetzung aufweisen; es einteilig ausgeführt ist; zumindest ein Rohrabschnitt X über eine Länge in axialer Richtung von 50 mm eine mittlere relative Dichte RDxm und zumindest ein Rohrabschnitt Y über eine Länge in axialer Richtung von 50 mm eine mittlere relative Dichte RDym aufweist, mit (RDym-RDxm)/RDym $\geq$ 0,001; ein Verhältnis aus der Gruppe (RDy-RDx)/RDy und (RDym-RDxm)/RDym $\geq$ 0,01 beträgt; zumindest ein Verhältnis aus der Gruppe (RDy-RDx)/RDy und (RDym-RDxm)/RDym $\leq$ 0,2 beträgt; es pulvermetallurgisch hergestellt ist; zumindest ein Rohrabschnitt X eine feine und gleichmäßige Porenstruktur aufweist; der Rohrabschnitt X zumindest bereichsweise einen größeren Außendurchmesser als der Rohrabschnitt Y aufweist; zumindest ein Rohrabschnitt X einen Außendurchmesser ADx und zumindest ein Rohrabschnitt Y einen Außendurchmesser ADy aufweist, wobei (ADx-ADy)/ADx $\geq$ 0,01 beträgt; (ADx-ADy)/ADx $\leq$ 0,3 beträgt; sich zwischen den Rohrabschnitt X und dem Rohrabschnitt Y ein Abschnitt Z befindet, wobei sich der Außendurchmesser im Abschnitt Z von ADx auf ADy ändert; zumindest ein Rohrabschnitt X konisch ausgeführt ist; dieses mit einem Trägerrohr aus einem nichtmagnetischen Werkstoff verbunden ist; dieses monolithisch ausgeführt ist; und/oder dieses zur Herstellung einer Rückkontaktschicht einer Dünnschicht-Solarzelle oder einer Funktionsschicht einer TFT Struktur verwendet wird.

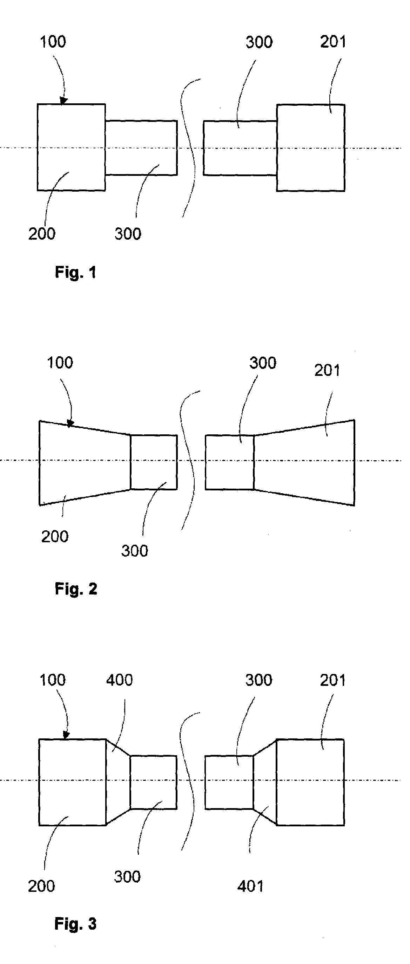

Im Folgenden ist die Erfindung beispielhaft beschrieben. Figur 1, Figur 2, Figur 3 und Figur 4 zeigen dabei schematisch die Außenkonturen der erfindungsgemäßen Ausführungsformen. Alle Ausführungsformen weisen Rohrform mit einem über die gesamte Länge konstanten Innendurchmesser auf, der jedoch in den Figuren nicht dargestellt ist. Die Dimensionen, insbesondere das Durchmesserverhältnis Rohrabschnitt X und Y, sind nicht maßstabsgetreu dargestellt.

Figur 1 zeigt ein erfindungsgemäßes Rohrtarget -100-, wobei die Rohrenden jeweils als Rohrabschnitte X ausgeführt und mit -200- und -201- bezeichnet sind. Zwischen den Rohrabschnitten -200- und -201- ist ein Rohrabschnitt -300- angeordnet. Die Rohrabschnitte X -200- und -201- weisen jeweils einen über deren gesamte Länge konstanten Außendurchmesser ADx. Auch der Rohrabschnitt Y -300- einen über die gesamte Länge konstanten Außendurchmesser ADy auf. Das Rohrtarget ist einteilig ausgeführt.

Figur 2 zeigt ein erfindungsgemäßes Rohrtarget -100-, wobei die Rohrenden jeweils als Rohrabschnitte X ausgeführt und mit -200- und -201- bezeichnet sind. Zwischen den Rohrabschnitten -200- und -201- ist ein Rohrabschnitt Y -300- angeordnet. Die Rohrabschnitte -200- und -201- sind konisch ausgeführt. Das Rohrtarget ist einteilig.

Figur 3 zeigt ein erfindungsgemäßes Rohrtarget -100-, wobei die Rohrenden jeweils als Rohrabschnitte X ausgeführt sind und mit -200- und -201- bezeichnet sind. Die Rohrabschnitte -200- und -201- weisen jeweils einen über die gesamte Länge konstanten Außendurchmesser ADx auf. Der mittlere Bereich des Rohrtargets -100- ist als Rohrabschnitt Y -300- ausgebildet.

Der Rohrabschnitt Y weist einen über die gesamte Länge konstanten Außendurchmesser ADy auf. Zwischen den Rohrabschnitten -200- und -300- sowie den Rohrabschnitten -201- und -300- befinden sich die Abschnitte Z -400- und -401-. Die Abschnitte Z -400- und -401- sind jeweils als Kegelstumpf ausgeführt. Das Rohrtarget ist einteilig.

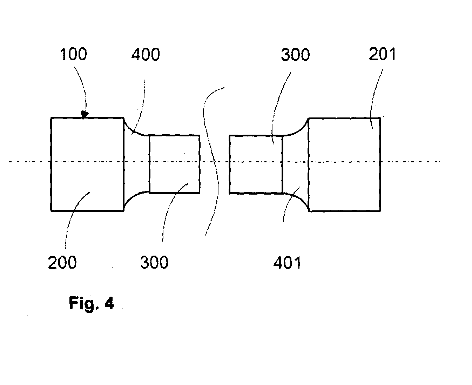

Figur 4 zeigt ein erfindungsgemäßes Rohrtarget -100-, wobei die Rohrenden jeweils als Rohrabschnitte X -200- und -201- ausgeführt sind. Der mittlere Bereich des Rohrtargets -100- ist als Rohrabschnitt Y -300- ausgebildet. Zwischen den Rohrabschnitten -200- und -300- sowie den Rohrabschnitten -201- und -300- befinden sich die Abschnitte Z -400- und -401-. Die Abschnitte Z -400- und -401- sind mit einem Radius ausgeführt. Das Rohrtarget -100- ist einteilig.

Nachfolgend ist die erfindungsgemäße Herstellung von Refraktärmetall-Rohrtargets beispielhaft beschrieben.

Beispiel 1:

Mo-Pulver mit einer Partikelgröße (FSSS) von 4,2 $\mu$m wurde in einen einseitig geschlossenen Gummischlauch mit einem Durchmesser von 420 mm gefüllt, in dessen Mitte ein Stahldorn mit einem Durchmesser von 147 mm positioniert war. Der Gummischlauch wurde verschlossen und in einer kaltisostatischen Presse bei einem Druck von 210 MPa verdichtet. Der Grünling wies eine relative Dichte von 0,65 auf. Der so hergestellte Grünling wurde in einem Indirekt-Sinterofen bei einer Temperatur von 1900 °C gesintert. Die relative Sinterdichte betrug 0,94.

Nach dem Sintervorgang wurde der Rohrrohling allseitig bearbeitet, wobei der Außendurchmesser 243 mm und der Innendurchmesser 130 mm betrug. Das Strangpressen erfolgte auf einer 3000 t Indirekt-Strangpresse. Der Rohrrohling wurde dazu auf eine Temperatur von 1250 °C erhitzt. In weiterer Folge wurde der Rohrrohling über einen Dorn gepresst, wodurch ein stranggepresstes Rohr mit einem Außendurchmesser von etwa 200 mm und einem Innendurchmesser von 125 mm entstand. Mittig wurde der vorverformte Rohrrohling mit einem Umformgrad |$\varphi$| von 0,03 durch Schmieden verformt, wodurch ein Rohrabschnitt -300- gemäß Figur 1 gebildet wurde. Die Rohrabschnitte X -200-, -201- wiesen jeweils eine Länge von 150 mm auf. Die Dichte wurde gemäß der Beschreibung bestimmt. Die Dichte betrug im Bereich Y nahezu 10,2 g/cm$^2$. (RDy - RDx) / RDy betrug 0,001.

Beispiel 2:

Die Herstellung des Rohrrohlings und das Strangpressen erfolgte gemäß Beispiel 1. Mittig wurde der vorverformte Rohrrohling mit einem Umformgrad |$\varphi$| von 0,33 durch Schmieden verformt, wodurch ein Rohrabschnitt -300- gemäß Figur 1 gebildet wurde. Die Rohrabschnitte X -200-, -201- wiesen jeweils eine Länge von 150 mm auf. Die Dichte wurde gemäß der Beschreibung bestimmt. Die Dichte betrug im Bereich Y 10,2 g/cm$^2$.

(RDy - RDx) / RDy betrug 0,005.

Beispiel 3:

Die Herstellung des Rohrrohlings erfolgte in Anlehnung an Beispiel 1, wobei nach allseitiger Bearbeitung des Rohrrohlings der Außendurchmesser 190 mm und der Innendurchmesser 130 mm betrug. Das anschließende Schmieden erfolgte auf einer 500 t Schmiedemaschine. Der Rohrrohling wurde dafür auf eine Temperatur von 1300°C erhitzt. Die Anfang- und Endbereiche des Rohres wurden gemäß Figur 1 über jeweils eine Länge von ca. 100 mm auf einen Außendurchmesser ADx von 169 mm mit einer Dichte von ca. 10,0 g/cm$^3$ und der Mittelbereich auf einen Außendurchmesser ADy=155 mm mit einer Dichte von ca. 10,2 g/cm$^3$ geschmiedet. (RDy - RDx) / RDy betrug 0,02.

Beispiel 4:

Die Herstellung des Rohrrohlings erfolgte in Anlehnung an Beispiel 1, wobei nach allseitiger Bearbeitung des Rohrrohlings der Außendurchmesser 175 mm und der Innendurchmesser 130 mm betrug. Das anschließende Schmieden erfolgte auf einer 500 t Schmiedemaschine. Der Rohrrohling wurde dafür auf eine Temperatur von 1300°C erhitzt. In weiterer Folge wurde der angewärmte Rohrrohling gemäß Figur 1 im Mittelbereich des Rohres auf einen Außendurchmesser ADy=155 mm mit einer Dichte von ca. 10,1 g/cm$^3$ geschmiedet. (RDy - RDx) / RDy betrug 0,05.

Beispiel 5:

Es wurde durch Sintern bei 1700°C eine Ronde mit einem Durchmesser von 60 mm und einer Dichte von 8,70 g/cm$^3$ hergestellt. Das Sputterverhalten wurde in weiterer Folge mit einem nahezu 100% dichten, verformten Material verglichen.

Beispiel 6:

Es wurde durch Sintern bei 1600°C eine Ronde mit einem Durchmesser von 60 mm und einer Dichte von 8,20 g/cm$^3$ hergestellt. Das Sputterverhalten wurde mit einem 100% dichten, verformten Material verglichen.

Die Charakterisierung der Proben aus den Beispielen 1 bis 6 erfolgte wie nachfolgend beschrieben. Aus den Bereichen X und Y wurden jeweils planare Versuchstargets mit einem Durchmesser von ca. 50 mm herausgearbeitet, bzw. die gesinterten Ronden gemäß den Beispielen 5 und 6 eingesetzt, geschliffen und auf eine Kupferrückplatte mittels Indium aufgelötet. Sputterversuche wurden bei 1 kW und 1,3 Pa Argon durchgeführt, wobei als Substrat ein Si Wafer diente. Die Versuchsdauer betrug 10 h.
Danach wurde der Targetabtrag bestimmt und der prozentuelle Unterschied ((Abtrag Probe Y - Abtrag Probe X) / Abtrag Probe Y) x 100 (in %) für die Beispiele 1 bis 4 bestimmt. Die Proben gemäß den Beispielen 5 und 6 wurden analog getestet, und der folgende prozentuelle Unterschied bestimmt: ((Abtrag Probe verformt - Abtrag Probe nur gesintert) / Abtrag Probe verformt) x 100 (in %). Für Beispiel 1 betrug dieses Verhältnis 1,0 %, für Beispiel 2 1,7 %, für Beispiel 3 1,9 %, für Beispiel 4 2,8 %, für Beispiel 5 8,1 % und für Beispiel 6 12,0 %. Keine Probe zeigte eine unzulässig erhöhte Neigung zum Arcen oder zur Teilchengenerierung.

Wie in der Beschreibung ausführlich geschildert, tritt bei Rohrtargets im Bereich der Rohrenden prozessbedingt ein verstärkter Abtrag auf. Wie hoch dieser verstärkte Abtrag ist, hängt von den Prozessbedingungen ab. Mit den Proben gemäß den Beispielen 1 bis 6 kann ein Unterschied von 1,0 bis 12% kompensiert werden. Der Fachmann kann daher in einfacher Weise zunächst den unterschiedlichen Abtrag an einem gemäß dem Stand der Technik hergestellten Rohrtarget ermitteln und dann den optimalen (RDy-RDx)/RDy - Wert durch wenige Versuche ermitteln.

**Patentansprüche**

1. Rohrtarget (100) aus Refraktärmetall oder einer Refraktärmetalllegierung mit einem Refraktärmetallgehalt ≥ 50 At.% umfassend zumindest einen Rohrabschnitt X (200,201) mit zumindest bereichsweise einer relativen Dichte RDx und zumindest einen Rohrabschnitt Y (300) mit zumindest bereichsweise einer relativen Dichte RDy, wobei zumindest ein Rohrabschnitt X (200,201) zumindest bereichsweise einen größeren Außendurchmesser als zumindest bereichsweise ein Rohrabschnitt Y (300) aufweist, **dadurch gekennzeichnet,**

   **dass** $\frac{RDy - RDx}{RDy} \geq 0{,}001$ beträgt.

2. Rohrtarget nach Anspruch 1, **dadurch gekennzeichnet, dass** zumindest ein Rohrabschnitt X (200,201) zumindest bereichsweise einen Außendurchmesser ADx und zumindest ein Rohrabschnitt Y (300) zumindest bereichsweise einen Außendurchmesser ADy aufweist, wobei $\frac{ADx - ADy}{ADx} \geq 0{,}01$ beträgt.

3. Rohrtarget nach Anspruch 2, **dadurch gekennzeichnet, dass** $\frac{ADx - ADy}{ADx} \leq 0{,}3$ beträgt.

4. Rohrtarget nach einem der vorangehenden Ansprüche, **dadurch gekennzeichnet, dass** die Rohrenden zumindest bereichsweise als Rohrabschnitte X (200,201) ausgebildet sind und zumindest ein Rohrabschnitt Y (300) dazwischen angeordnet ist, der sich in axialer Richtung über einen längeren Bereich erstreckt, als die Summe der axialen Erstreckung der Rohrabschnitte X (200,201).

5. Rohrtarget nach einem der vorangehenden Ansprüche, **dadurch gekennzeichnet, dass** zumindest zwischen einem Rohrabschnitt X (200,201) und einem Rohrabschnitt Y (300) ein Abschnitt Z (400,401) angeordnet ist, wobei sich der Außendurchmesser im Abschnitt Z (400,401) von ADx auf ADy ändert.

6. Rohrtarget nach einem der vorangehenden Ansprüche, **dadurch gekennzeichnet, dass** zumindest ein Rohrabschnitt X (200, 201) konisch ausgeführt ist.

7. Rohrtarget nach einem der vorangehenden Ansprüche, **dadurch gekennzeichnet, dass** es pulvermetallurgisch hergestellt ist.

8. Rohrtarget nach einem der vorangehenden Ansprüche, **dadurch gekennzeichnet, dass** zumindest ein Rohrabschnitt X (200,201) eine feine und gleichmäßige Porenstruktur aufweist, wobei der mittlere Porendurchmesser 10 nm bis 10 $\mu$m beträgt.

9. Rohrtarget nach einem der vorangehenden Ansprüche, **dadurch gekennzeichnet, dass** dieses aus einem Werkstoff der Gruppe Molybdän, Molybdänlegierung, Wolfram, Wolframlegierung, Chrom und Chromlegierung besteht.

10. Rohrtarget nach einem der vorangehenden Ansprüche, **dadurch gekennzeichnet, dass** alle Rohrabschnitte X (200,201) und alle Rohrabschnitte Y (300) dieselbe Werkstoffzusammensetzung aufweisen.

11. Rohrtarget nach einem der vorangehenden Ansprüche, **dadurch gekennzeichnet, dass** es einteilig ausgeführt ist.

12. Rohrtarget nach einem der vorangehenden Ansprüche, **dadurch gekennzeichnet, dass** zumindest ein Rohrabschnitt Y (300) eine relative Dichte von 99 bis 100% aufweist.

13. Rohrtarget nach einem der vorangehenden Ansprüche, **dadurch gekennzeichnet, dass** zumindest ein Rohrabschnitt X (200,201) zumindest bereichsweise über eine Länge in axialer Richtung von 50 mm eine mittlere relative Dichte RDxm und zumindest ein Rohrabschnitt Y (300) zumindest bereichsweise über eine Länge in axialer Richtung von 50 mm eine mittlere relative Dichte RDym aufweist, mit

$$\frac{RDym-RDxm}{RDym} \geq 0{,}001.$$

14. Rohrtarget nach Anspruch 13, **dadurch gekenn-**

**zeichnet, dass** zumindest ein Verhältnis aus der Gruppe $\dfrac{RDy-RDx}{RDy}$ und $\dfrac{RDym-RDxm}{RDym} \geq 0{,}01$ beträgt.

15. Rohrtarget nach Anspruch 13 oder 14, **dadurch gekennzeichnet, dass** zumindest ein Verhältnis aus der Gruppe $\dfrac{RDy-RDx}{RDy}$ und $\dfrac{RDym-RDxm}{RDym} \leq 0{,}2$ beträgt.

16. Verwendung eines Rohrtargets nach einem der vorangehenden Ansprüche zur Herstellung einer Funktionsschicht einer Dünnschicht-Solarzelle oder einer TFT Struktur.

17. Verfahren zur Herstellung eines Rohrtargets (100) nach einem der Ansprüche 1 bis 15, wobei das Verfahren zumindest folgende Schritte umfasst:

   - Herstellen eines Grünlings durch Pressen eines Pulvers mit einem Pressdruck p, mit 100 MPa < p < 400 MPa;
   - Herstellen eines Rohrrohlings durch druckloses oder druckunterstütztes Sintern bei 0,4 bis 0,9 homologe Temperatur;
   - Verformen des Rohrrohlings in einem Bereich, der im fertigen Rohrtarget (100) dem Rohrabschnitt Y (300) entspricht, dergestalt, dass zumindest bereichsweise der Umformgrad höher ist, als zumindest bereichsweise in einem Bereich, der im fertigen Rohrtarget (100) dem Rohrabschnitt X (200,201) entspricht;
   - Optional mechanische Bearbeitung.

18. Verfahren nach Anspruch 17, **dadurch gekennzeichnet, dass** der Rohrrohling in einem Bereich, der im fertigen Rohrtarget (100) dem Rohrabschnitt Y (300) entspricht, zumindest bereichsweise um $|\varphi| \geq 0{,}03$ höher verformt wird, als zumindest bereichsweise in einem Bereich, der im fertigen Rohrtarget (100) dem Rohrabschnitt X (200,201) entspricht.

19. Verfahren nach Anspruch 17 oder 18, **dadurch gekennzeichnet, dass** der Rohrrohling eine relative Dichte RDr aufweist, mit RDr $0{,}8 \leq$ RDr $\leq 0{,}995$.

20. Verfahren nach einem der Ansprüche 17 bis 19, **dadurch gekennzeichnet, dass** der Grünling durch kaltisostatisches Pressen hergestellt wird, wobei der Grünling eine Form aufweist, ausgewählt aus der Gruppe, Rohr, Zylinder, Rohr mit bereichsweise größerem Außendurchmesser und Zylinder mit bereichsweise größerem Außendurchmesser.

21. Verfahren nach einem der Ansprüche 17 bis 20, **da-**

**durch gekennzeichnet, dass** der Rohrabschnitt X zumindest bereichsweise nicht verformt ist.

22. Verfahren nach einem der Ansprüche 17 bis 21, **dadurch gekennzeichnet, dass** der Rohrrohling durch zumindest ein Verfahren der Gruppe Schmieden Strangpressen und Drückwalzen verformt wird.

23. Verfahren nach einem der Ansprüche 17 bis 22, **dadurch gekennzeichnet, dass** durch mechanische Bearbeitung des verformten Rohrrohlings ein Rohrtarget (100) hergestellt wird und dieses optional mit einem Trägerrohr verbunden wird.

**Claims**

1. Tubular target (100) composed of refractory metal or a refractory metal alloy have a refractory metal content of $\geq$ 50 atom%, which comprises at least one tubular section X (200, 201) having at least in regions a relative density RDx and at least one tubular section Y (300) having at least in regions a relative density RDy, where at least one tubular section X (200, 201) has at least in regions a greater external diameter than at least in regions a tubular section Y (300), **characterized in that** $\dfrac{RDy - RDx}{RDy}$ is $\geq 0.001$.

2. Tubular target according to Claim 1 , **characterized in that** at least one tubular section X (200, 201) has at least in regions an external diameter ADx and at least one tubular section Y (300) has at least in regions an external diameter ADy, where $\dfrac{ADx - ADy}{ADx}$ is $\geq 0,01$.

3. Tubular target according to Claim 2, **characterized in that** $\dfrac{ADx - ADy}{ADx}$ is $\leq 0.3$.

4. Tubular target according to any of the preceding claims, **characterized in that** the ends of the tube are at least in regions configured as tubular sections X (200, 201) and at least one tubular section Y (300) which extends in the axial direction over a longer region than the sum of the axial extension of the tubular sections X (200, 201) is arranged in between.

5. Tubular target according to any of the preceding claims, **characterized in that** a section Z (400, 401) is arranged at least between a tubular section X (200, 201) and a tubular section Y (300), with the external diameter changing from ADx to ADy in the section Z (400, 401).

6. Tubular target according to any of the preceding claims, **characterized in that** at least one tubular section X (200, 201) is conical.

7. Tubular target according to any of the preceding claims, **characterized in that** it is produced by powder metallurgy.

8. Tubular target according to any of the preceding claims, **characterized in that** at least one tubular section X (200, 201) has a fine and uniform pore structure, where the average pore diameter is from 10 nm to 10 $\mu$m.

9. Tubular target according to any of the preceding claims, **characterized in that** it consists of a material from the group consisting of molybdenum, a molybdenum alloy, tungsten, a tungsten alloy, chromium and a chromium alloy.

10. Tubular target according to any of the preceding claims, **characterized in that** all tubular sections X (200, 201) and all tubular sections Y (300) have the same materials composition.

11. Tubular target according to any of the preceding claims, **characterized in that** it is made in one piece.

12. Tubular target according to any of the preceding claims, **characterized in that** at least one tubular section Y (300) has a relative density of from 99 to 100%.

13. Tubular target according to any of the preceding claims, **characterized in that** at least one tubular section X (200, 201) has an average density RDxm at least in regions over a length in the axial direction of 50 mm and at least one tubular section Y (300) has an average relative density RDym at least in regions over a length in the axial direction of 50 mm, where $\dfrac{RDym - RDxm}{RDym} \geq 0.001$.

14. Tubular target according to Claim 13, **characterized in that** at least one ratio from the group $\dfrac{RDy - RDx}{RDy}$ and $\dfrac{RDym - RDxm}{RDym}$ is $\geq 0.01$.

15. Tubular target according to Claim 13 or 14, **characterized in that** at least one ratio from the group $\dfrac{RDy - RDx}{RDy}$ and $\dfrac{RDym - RDxm}{RDym}$ is $\leq 0.2$.

16. Use of a tubular target according to any of the preceding claims for producing a functional layer of a thin-film solar cell or a TFT structure.

**17.** Process for producing a tubular target (100) according to any of Claims 1 to 15, where the process comprises at least the following steps:

- production of a green body by pressing a powder at a pressing pressure p, where 100 MPa < p < 400 MPa;
- production of a tubular blank by pressureless or pressure-aided sintering at a homologous temperature of from 0.4 to 0.9;
- deformation of the tubular blank in a region which in the finished tubular target (100) corresponds to the tubular section Y (300) so that the degree of deformation is at least in regions higher than that at least in regions in a region which corresponds in the finished tubular target (100) to the tubular section X (200, 201);
- optionally mechanical shaping.

**18.** Process according to Claim 17, **characterized in that** the tubular blank is deformed at least in regions by $|\varphi| \geq 0.03$ in a region which in the finished tubular target (100) corresponds to the tubular section X (300) to a greater extent than that at least in regions in a region which in the finished tubular target (100) corresponds to the tubular section X (200, 201).

**19.** Process according to Claim 17 or 18, **characterized in that** the tubular blank has a relative density RDr, where RDr $0.8 \leq$ RDr $\leq 0.995$.

**20.** Process according to any of Claims 17 to 19, **characterized in that** the green body is produced by cold isostatic pressing, where the green body has a shape selected from the group consisting of a tube, a cylinder, a tube having a greater external diameter in regions and a cylinder having a greater external diameter in regions.

**21.** Process according to any of Claims 17 to 20, **characterized in that** the tubular section X is not deformed at least in regions.

**22.** Process according to any of Claims 17 to 21, **characterized in that** the tubular blank is deformed by at least one process from the group consisting of forging, extrusion and pressure rolling.

**23.** Process according to any of Claims 17 to 22, **characterized in that** a tubular target (100) is produced by mechanical shaping of the deformed tubular blank and this is optionally joined to a support tube.

## Revendications

**1.** Cible tubulaire (100) en métal réfractaire ou en alliage de métal réfractaire avec une teneur en métal réfractaire $\geq$ 50 At. % comprenant au moins une section tubulaire X (200,201) avec au moins par endroits une densité relative RDx et au moins une section tubulaire Y (300) avec au moins par endroits une densité relative RDy, où au moins une section tubulaire X (200,201) présente au moins par endroits un diamètre externe plus important qu'une section tubulaire Y (300) au moins par endroits, **caractérisée en ce que**

$$\frac{RDy-RDx}{RDy} \geq 0,001.$$

**2.** Cible tubulaire selon la revendication 1, **caractérisée en ce qu'**au moins une section tubulaire X (200,201) présente au moins par endroits un diamètre externe ADx et au moins une section tubulaire Y (300) présente au moins par endroits un diamètre externe ADy, où

$$\frac{ADx-ADy}{ADx} \geq 0,01.$$

**3.** Cible tubulaire selon la revendication 2, caractérisée en ce $\frac{ADx-ADy}{ADx} \leq 0,3.$

**4.** Cible tubulaire selon l'une quelconque des revendications précédentes, **caractérisée en ce que** les extrémités tubulaires sont en forme de sections tubulaires X (200,201) au moins par endroits et qu'au minimum une section tubulaire Y (300) est disposée entre celles-ci, section s'étendant dans la direction axiale sur une zone plus longue que la somme de l'extension axiale des sections tubulaires X (200,201).

**5.** Cible tubulaire selon l'une quelconque des revendications précédentes, **caractérisée en ce qu'**au moins une section Z (400,401 est disposée entre une section tubulaire X (200,201) et une section tubulaire Y (300), où le diamètre externe change d'ADx à Ady dans la section Z (400,401).

**6.** Cible tubulaire selon l'une quelconque des revendications précédentes, **caractérisée en ce qu'**au moins une section tubulaire X (200, 201) est conique.

**7.** Cible tubulaire selon l'une quelconque des revendications précédentes, **caractérisée en ce qu'**elle est fabriquée par métallurgie des poudres.

**8.** Cible tubulaire selon l'une quelconque des revendications précédentes, **caractérisée en ce qu'**au moins une section tubulaire X (200,201) présente une structure de pores fine et régulière où le diamètre de pores moyen est compris entre 10 nm et 10 $\mu$m.

**9.** Cible tubulaire selon l'une quelconque des revendications précédentes, **caractérisée en ce que** ladite cible se compose d'un matériau pris parmi le groupe composé de molybdène, d'un alliage de molybdène, de tungstène, d'un alliage de tungstène, de chrome et d'un alliage de chrome.

**10.** Cible tubulaire selon l'une quelconque des revendications précédentes, **caractérisée en ce que** toutes les sections tubulaires X (200,201) et toutes les sections tubulaires Y (300) présentant la même composition de matériau.

**11.** Cible tubulaire selon l'une quelconque des revendications précédentes, **caractérisée en ce qu'**elle est tout d'une pièce.

**12.** Cible tubulaire selon l'une quelconque des revendications précédentes, **caractérisée en ce qu'**au moins une section tubulaire Y (300) présente une densité relative de 99 à 100%.

**13.** Cible tubulaire selon l'une quelconque des revendications précédentes, **caractérisée en ce qu'**au moins une section tubulaire X (200,201) présente au moins par endroits une densité relative moyenne RDxm sur une longueur dans la direction axiale de 50 mm et au moins une section tubulaire Y (300) présente au moins par endroits une densité relative moyenne RDym sur une longueur dans la direction axiale de 50 mm, avec

$$\frac{RDym - RDxm}{RDym} \geq 0{,}001$$

**14.** Cible tubulaire selon la revendication 13, **caractérisée en ce qu'**au moins un rapport entre le groupe

$$\frac{RDy - RDx}{RDy} \text{ et le groupe } \frac{RDym - RDxm}{RDym} \text{ est} \geq 0{,}01.$$

**15.** Cible tubulaire selon la revendication 13 ou la revendication 14, **caractérisée en ce qu'**au moins un rapport ente le groupe $\frac{RDy - RDx}{RDy}$ et le groupe

$$\frac{RDym - RDxm}{RDym} \text{ est} \leq 0{,}2.$$

**16.** Utilisation d'une cible tubulaire selon l'une quelconque des revendications précédentes pour la fabrication d'une couche fonctionnelle d'une cellule solaire micromorphe ou d'une structure TFT.

**17.** Procédé de fabrication d'une cible tubulaire (100) selon l'une des revendications 1 à 15, où ledit procédé comprend au moins les phases suivantes :

- Fabrication d'une ébauche par compression d'une poudre avec une pression de pressage p, avec 100 MPa < p < 400 Mpa ;
- Fabrication d'une ébauche tubulaire par frittage sans pression ou à pression positive à une température homologue de 0,4 à 0,9 ;
- déformation de l'ébauche tubulaire dans une zone correspondant à la section tubulaire Y (300) dans la cible tubulaire finie (100), de telle sorte qu'au moins par endroits le degré de déformation est supérieur au moins par endroits à une zone correspondant à la section tubulaire X (200,201) dans la cible tubulaire (100) ;
- Traitement mécanique en option.

**18.** Procédé selon la revendication 17, **caractérisé en ce que** l'ébauche tubulaire dans une zone correspondant à la section tubulaire Y (300) dans la cible tubulaire (100) est déformée au moins par endroits de $|\varphi| > 0{,}03$ plus qu'au moins par endroits dans une zone correspondant à la section tubulaire X (200,201) dans la cible tubulaire (100).

**19.** Procédé selon la revendication 17 ou la revendication 18, **caractérisé en ce que** l'ébauche tubulaire présente une densité relative RDr, avec RDr 0,8 < RDr < 0,995.

**20.** Procédé selon l'une quelconque des revendications 17 à 19, **caractérisé en ce que** l'ébauche est produite par compression isostatique à froid, où l'ébauche présente une forme sélectionnée par le groupe composé d'un tube, d'un cylindre, d'un tube de diamètre externe plus grand par endroits et d'un cylindre de diamètre externe plus grand par endroits.

**21.** Procédé selon l'une quelconque des revendications 17 à 20, **caractérisé en ce que** la section tubulaire X n'est pas déformée au moins par endroits.

**22.** Procédé selon l'une quelconque des revendications 17 à 21, **caractérisé en ce que** l'ébauche est déformée par au moins un procédé choisi parmi le groupe composé de forgeage, de filage et de fluotournage.

**23.** Procédé selon l'une quelconque des revendications 17 à 22, **caractérisé en ce que** l'on obtient une cible tubulaire par traitement mécanique de l'ébauche tubulaire déformée et que ladite cible tubulaire est connectée de manière optimale à un tube porteur.

**Fig. 1**

**Fig. 2**

**Fig. 3**

EP 2 769 002 B1

Fig. 4

14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0586809 A1
- WO 2007141173 A1
- WO 2007141174 A1
- US 5725746 A
- WO 2007041730 A1
- EP 1937866 A1